# EUROPÄISCHE PATENTSCHRIFT

(11) **EP 1 495 341 B1**
(45) Veröffentlichungstag und Bekanntmachung des Hinweises auf die Patenterteilung: **30.07.2008**
(21) Anmeldenummer: 03727298.6
(22) Anmeldetag: 12.04.2003
(51) Int. Cl.: G01R 33/38, G01R 33/341, G01N 24/08

(54) **NMR-SONDE ZUR MATERIALANALYSE**
NMR PROBE USED TO ANALYZE MATERIALS
SONDE D'IMAGERIE PAR RESONANCE MAGNETIQUE CONCUE POUR DES ANALYSES DE MATERIAU

(30) Priorität: 14.04.2002 DE 10216587
(43) Veröffentlichungstag der Anmeldung: 12.01.2005
(73) Patentinhaber: Blümich, Bernhard, Prof. Dr., 52159 Roetgen (DE)
(72) Erfinder: BLÜMICH, Bernhard, 52159 Roetgen (DE); BRUDER, Michael, 22147 Hamburg (DE); ANFEROV, Vladimir, Kaliningrad, 236039 (RU); ANFEROVA, Sophia, Kaliningrad 236039 (RU); FECHETE, Radu, R-4300 TG-Mures (RO); KLEIN, Martin, 52062 Aachen (DE); KRAUSE, Karl-Heinz, 09123 Chemnitz (DE); RABKIN, Michael, 22089 Hamburg (DE); STANGENBERG, Jürgen, 21079 Hamburg (DE)
(74) Vertreter: Metz, Siegfried
(86) Internationale Anmeldenummer: PCT/EP2003/003823
(87) Internationale Veröffentlichungsnummer: WO 2003/087861

(56) Entgegenhaltungen:
- EP-A- 0 347 180
- WO-A-99/54747
- US-A- 5 390 673
- US-B1- 6 326 787
- ANFEROVA S. ET AL: "Construction of a NMR-MOUSE with short dead time" CONCEPTS IN MAGNETIC RESONANCE, MAGNETIC RESONANCE ENGINEERING, Bd. 15, Nr. 1, 13. März 2002 (2002-03-13), Seiten 15-25, XP002248302
- BLÜMICH B. ET AL: "Unilateral Nuclear Magnetic Resonance for Quality Control - The NMR-MOUSE" SPECTROSCOPY MAGAZINE, Bd. 18, Nr. 2, Februar 2003 (2003-02), Seite 18,20,22,24,26,28,30,32,73 XP002248303
- ANFEROV V. ET AL: "The NMR-MOUSE for Quality Control in the Rubber Industry" AIXNMR, [Online] Nr. 2, November 2002 (2002-11), Seiten 2-4, XP002248304 Rott, Germany Gefunden im Internet: <URL:http://www.aixnmr.com/issue02_112002. pdf> [gefunden am 2003-07-17]
- BLUEMICH B ET AL: "THE NMR-MOUSE: CONSTRUCTION, EXCITATION, AND APPLICATIONS" MAGNETIC RESONANCE IMAGING, TARRYTOWN, NY, US, Bd. 16, Nr. 5/6, Juni 1998 (1998-06), Seiten 479-484, XP000918278 ISSN: 0730-725X
- PATENT ABSTRACTS OF JAPAN vol. 017, no. 349 (C-1078), 2. Juli 1993 (1993-07-02) & JP 05 049614 A (TOSHIBA CORP), 2. März 1993 (1993-03-02)

## Beschreibung

Die Erfindung betrifft eine NMR-Sonde zur Materialanalyse mit einem Magneten zur Erzeugung eines konstanten Polarisationsfeldes *B₀* im zu untersuchenden Material und mit an dem Magneten angebrachten flachen Oberflächenspulen zur Erzeugung eines gepulsten hochfrequenten magnetischen in werentlichen orthogonal zum Polarisationsfeld B₀ ausgerichteten Anregungsfeldes B₁ im Strenfeld des Magneten, ausserhalb der sich aus Magnet und Oberflächenspulen zusammensetzenden Sondeneinheit.

Bei einer Anwendung der Sonde werden im Material Echosignale S erzeugt, die als Material charakteristische Meßgrößen von der NMR-Sonde ermittelt werden. Die Echosignale sind zeitlich nach einer Änderung des Magnetfeldes durch ein oder mehrere von der NMR-Sonde abgegebene Signalimpulse jeweils nach einer Echozeit t_{E} meßbar. Das Meßsignal wird im Umfeld der Sonde in dem Magnetfeldbereich erzeugt, in dem die Komponenten der beiden Magnetfelder *B*₀ und *B*₁ orthogonal zueinander stehen.

Eine unilaterale NMR-Sonde, z.B. eine Sonde vom Typ NMR-MOUSE (Nuclear Magnetic Resonance - MObile Universal Surface Explorer), ist ein mobiles Meßgerät, mit dem zur Analyse von Materialien kernmagnetische Resonanz angewandt wird. Mit einer NMR-MOUSE lassen sich räumliche Materialstrukturen untersuchen: Sowohl kristalline oder glasige Werkstoffe, als auch weiche Materialien, wie z.B. Elastomere bezüglich ihrer molekularen Dynamik, und Flüssigkeiten sowie biologisches Material sind analysierbar, siehe z.B. G.Eidmann et al, "The NMR MOUSE, a mobile universal surface explorer", Journal of Magnetic Resonance, 1996, S. 104/109, sowie P.Blümler et al, "Spatially resolved magnetic resonance", Wiley-VCH-Verlag, 1998, S.195/209, oder A.Guthausen et al, "NMR-Bildgebung und Materialforschung", Chemie in unserer Zeit, 1998, S.73/82.. Das zeitlich konstante, statische magnetische Polarisationsfeld *B*₀ wird bei der NMR-MOUSE meist mittels eines oder mehrerer Permanentmagneten erzeugt, das gepulste magnetische Anregungsfeld *B₁* ist der magnetische Anteil eines Hochfrequenzfeldes, das mit einer Hochfrequenzspule, im folgenden HF-Spule bezeichnet, als Bestandteil eines elektrischen Schwingkreises gebildet wird, wobei die HF-Spule gewöhnlich zugleich auch als Empfängerspule für die zu messenden Echosignale S dient. Bei der NMR-MOUSE wird zur Polarisation der Kernmagnetisierung im permanentmagnetischen Polarisationsfeld *B₀* und zur Erzeugung und Detektion der Meßsignale auf räumlich homogene Magnetfelder verzichtet. NMR-MOUSE-Sonden können somit im Verhältnis zu üblichen NMR-Geräten klein und kostengünstig gebaut werden. Dabei definieren Form und Größe des Umgebungsvolumens, das im Umfeld kernmagnetisch genutzt wird und durch Messen der Echosignale zu detektieren ist, einerseits die orthogonalen Komponenten beider Magnetfelder *B₀* und *B₁* und andererseits die Bandbreite der Hochfrequenzimpulse und deren zeitliche Abfolge. Der Verlauf der magnetischen Feldlinien kann durch Dimensionierung und Anordnung der Permanentmagnete und der Spule des elektrischen Hochfrequenzschwingkreises verändert werden.

Aus Anferova S. et al, Concepts in Magnetic Resonance, Magnetic Resonance Engineering, vol. 15, no. 1, 2002, 5, 15-25 ist ein NMR-MOUSE-gerät bekannt, das sich einer planaren, in Form einer '8' ausgestalteten Oberflächenspule bedient.

Aus DE 199 28 039 A1 ist ein NMR-MOUSE-Gerät zur Untersuchung von Flächenware aus polymeren Werkstoffen mit eingebetteten textilen Festigkeitsträgern bekannt, bei dem mehrere auf einem Meßkörper benachbart angeordnete NMR-MOUSE-Sonden eine Meßebene zur Auflage der Flächenware (3) bilden. Die Flächenware wird von ihrer Oberfläche her abgetastet, die Eindringtiefe der Anregungsfelder ist von der Dimensionierung der NMR-MOUSE-Sonden abhängig. Dabei ist der räumliche Meßbereich im zu untersuchenden Material dreidimensional durch Verschieben der NMR-MOUSE, durch Verformen der Magnetfelder über Zusatzspulen und durch Änderung des Hochfrequenzfeldes variierbar. Nachteilig ist bei den bisher konzipierten NMR-MOUSE-Geräten, daß die gegebenen Inhomogenitäten des permanentmagnetischen Polarisationsfeldes *B₀* und des Anregungsfeldes *B₁* zu einer unbefriedigenden Ausbeute der Meßsignale aus dem von einer NMR-MOUSE-Sonde über den Hochfrequenzschwingkreis angeregten Volumenbereich führt. Das Signal-zu-Rausch-Verhältnis genügt hohen Anforderungen nicht, vor allem dann nicht, wenn dünne Materialschichten zu untersuchen sind.

Aufgabe der Erfindung ist es, das Signal-zu-Rausch-Verhältnis für NMR-Sonden zu verbessern, wobei eine Optimierung der Eindringtiefe des Meßvolumens unter Berücksichtigung der jeweiligen Materialstärke des zu analysierenden Materials angestrebt wird.

Diese Aufgabe wird bei einer NMR-Sonde der eingangs genannten Art durch die in Patentanspruch 1 angegebenen Merkmale gelöst.

Um die Resonanzbedingungen der NMR zu erfüllen, müssen nicht nur die Larmor-Frequenz der Kernmagnetisierung und die Frequenz der Hochfrequenzanregung übereinstimmen, es müssen darüber hinaus auch das Polarisationsfeld *B₀* und das Anregungsfeld *B₁* des Hochfrequenzschwingkreises senkrecht aufeinander stehen. Werden von den Stromleitern zur Ausbildung von orthogonal zum Polarisationsfeld *B₀* ausgerichteten Querkomponenten mehrere benachbart angeordnete alternierende Anregungsfelder erzeugt, erhöht sich im vom Hochfrequenzschwingkreis insgesamt angeregten Materialvolumen die Dichte der Magnetfeldlinien, die die Orthogonalitätsbedingung im Polarisationsfeld erfüllen. Auch im gegebenen inhomogenen Polaritätsfeld wird somit das Signal-zu-Rausch-Verhältnis zugunsten einer höheren Signalausbeute verbessert. Je mehr Anregungsfelder erzeugt werden, um so höher ist die Empfindlichkeit der Sonde, wobei die Eindringtiefe der Anregungsfelder jeweils von der Anordnung und Ausbildung der Stromleiter bestimmt wird. Maßgebend ist ein charakteristischer Abstand derjenigen Stromleiter oder Stromleiterbereiche, die jeweils eines der alternierenden Anregungsfelder erzeugen. Werden die Anregungsfelder beispielsweise von in einer Ebene angeordneten flächigen Hochfrequenzspulen erzeugt, ist für die Eindringtiefe des Anregungsfeldes der Radius einer Leiterschleife der Hochfrequenzspule und für die Empfindlichkeit der Abstand zwischen den alternierend betriebenen Hochfrequenzspulen maßgebend. Die Eindringtiefe nimmt mit kleiner werdendem Radius ab, die Empfindlichkeit mit kleiner werdendem Abstand zu, der Spulenradius und die Anzahl der pro Flächeneinheit in der Ebene angeordneten HF-Spulen geben somit das Maß für das von der NMR-Sonde analysierbare Materialvolumen. Damit läßt sich die NMR-Sonde über den gewählten Abstand der Stromleiter des Hochfrequenzschwingkreises auf die Stärke des zu untersuchenden Materials einstellen und zugleich bezüglich des Signal-zu-Rausch-Verhältnisses optimieren.

Der Hochfrequenzschwingkreisweist in einer senkrecht zum Polarisationsfeld *B₀* verlaufenden Ebene mehrere nebeneinander angeordnete gegenphasig betriebene Leiterschlaufen auf. Zwischen den Leiterschlaufen werden somit Anregungsfelder mit alternierenden Magnetfeldrichtungen erzeugt. Der für die Eindringtiefe der Anregungsfelder charakteristische Abstand ist der Radius r der Leiterschlaufen. Die Empfindlichkeit der Sonde wird bestimmt durch die Anzahl der Leiterschlaufen pro Flächeneinheit der Ebene, in der sie angeordnet sind. Je kleiner die Leiterschlaufen und je enger sie angeordnet sind, um so höher ist die Empfindlichkeit der Sonde für dünne Schichten.

Die benachbart angeordneten flächigen Leiterschlaufen können von einem einzigen Stromleiter geformt und hintereinander geschaltet sein. Bei Einzelbetrieb der Schlaufen lassen sich jeweils lokale Meßwerte analysieren und Materialdifferenzen zwischen den Meßstellen der einzelnen Hochfrequenzspulen feststellen.

Bevorzugte Leiterschleifenformen, zur Ausbildung des benachbarten Leiterschlaufen sind Leiterschleifen, die in Form der Zahl "8" verlaufen, oder kleeblattförmige Leiterschleifen.

Zweckmäßig ist es die Stromleiter in oder auf einem gesonderten Träger anzubringen, der mit dem das Polarisationsfeld *B₀* erzeugenden Magneten verbindbar ist. Als Trägermaterial wird elektrisch nicht leitendes Material, insbesondere Silizium, Glas oder Keramik verwendet. Der Träger kann für die mit der NMR-Sonde durchzuführenden Untersuchungen in gesonderter Weise materialspezifisch ausgebildet sein. Zur Vermeidung einer Benetzung mit Wasser wird die Trägeroberfläche hydrophob ausgebildet, Anspruch 4. Um den Träger auf dem Polarisationsmagneten in einfacher Weise befestigen zu können, ist nach Anspruch 5 eine Halterung für den Träger vorgesehen, die magnetisch auf dem Polarisationsmagneten haftet. Als Halterung dient bevorzugt ein Stahlblech, Anspruch 6.

Die sich mit den vorgenannten NMR-Sonden bei kleinen charakteristischen Abständen der Stromleiter zur Ausbildung des Hochfrequenzschwingkreise erreichbaren kleinen Meßvolumina lassen sich vorteilhaft durch kurze HF-Impulse von wenigen Mikrosekunden Dauer anregen. Innerhalb eines solchen kleinen Materialvolumens sind auch nur geringe Feldschwankungen im Polarisationsfeld *B₀* gegeben, so daß für die erfindungsgemäße Spulenanordnung optimale Orthogonalitätsbedingungen zwischen Polarisationsfeld *B₀* und Anregungsfelder *B₁* vorliegen. Der Füllfaktor, der das Verhältnis von Materialvolumen, das zu analysieren ist, zum Meßvolumen angibt, das von der NMR-Sonde erfaßt wird, ist für dünne Materialproben daher optimal einstellbar. Für dünne Materialien ist bei Einsatz miniaturisierter HF-Spulen eine Maximierung des Signal-zu-Rausch-Verhältnisses zu erreichen. Damit bieten sich derartige NMR-Sonden zur Analyse von Oberflächen-Beschichtungen aus nicht elektrisch leitfähigem Material an, beispielsweise zur Analyse von Lackierungen oder Beschichtungen mit Folien. Eine weitere bevorzugte Anwendung ist die Analyse dünner Materialien, insbesondere von Folien selbst, von Membranen oder Papierbahnen, insbesondere bei dünnen Materialien zur Feststellung ihrer Dicke und Homogenität.

Für eine Anwendung unilateraler NMR-Geräte als Sensor ist es zweckmäßig, die Stromleiter, die zur Erzeugung des Anregungsfeldes *B₁* dienen, auf ihrer dem Polarisationsmagneten zur Erzeugung des Polarisationsfeldes *B₀* abgewandten freien Oberfläche mit einer Schicht zu bedecken, die auf ihr äußeres Umfeld sensorisch mit einer Änderung der von der NMR-Sonde zu messenden Echosignale reagiert, Anspruch 7. Eine solche Anwendung und Ausbildung der NMR-Sonde ist unabhängig von einer Anordnung mehrerer HF-Spulen möglich. Als sensorische Schicht lassen sich die Stromleiter mit einer sensorisch reagierenden Folie bedecken, Anspruch 8. Bevorzugt wird jedoch nach Anspruch 9 auf den oder die Stromleiter eine Beschichtung aufgebracht, die für den Anwendungsfall jeweils chemisch funktionalisierte Moleküle enthält. Das Anwendungsfeld einer NMR-Sonde als Sensor ist bei dieser Ausbildung sehr weit gesteckt, für ihren Einsatz bedarf es lediglich einer auf das NMR-Gerät aufgebrachten Schicht, die auf die zu erwartende Reaktion im Umfeld chemisch geeignet eingestellt ist und bei einer Reaktion das von der NMR-Sonde gemessene Echosignal verändert.

Wegen ihrer hohen Qualität und Eignung für die Analyse dünner Schichten und ihrer hohe Empfindlichkeit im oberflächennahen Bereich sind die vorbeschriebenen NMR-Sonden als Sensoren besonders bevorzugt geeignet.

Die Erfindung und weitere Ausgestaltungen der Erfindung werden nachfolgend anhand von Ausführungsbeispielen beschrieben. Die Zeichnung zeigt im einzelnen:
- Figur 1: Prinzipskizze
- Figur 2: NMR-Sonde mit HF-Spulen auf einer der Polflächen eines stabförmigen Permanentmagneten
- Figur 3: NMR-Sonde mit kleeblattartig geformten Leiterschleifen einer HF-Spule

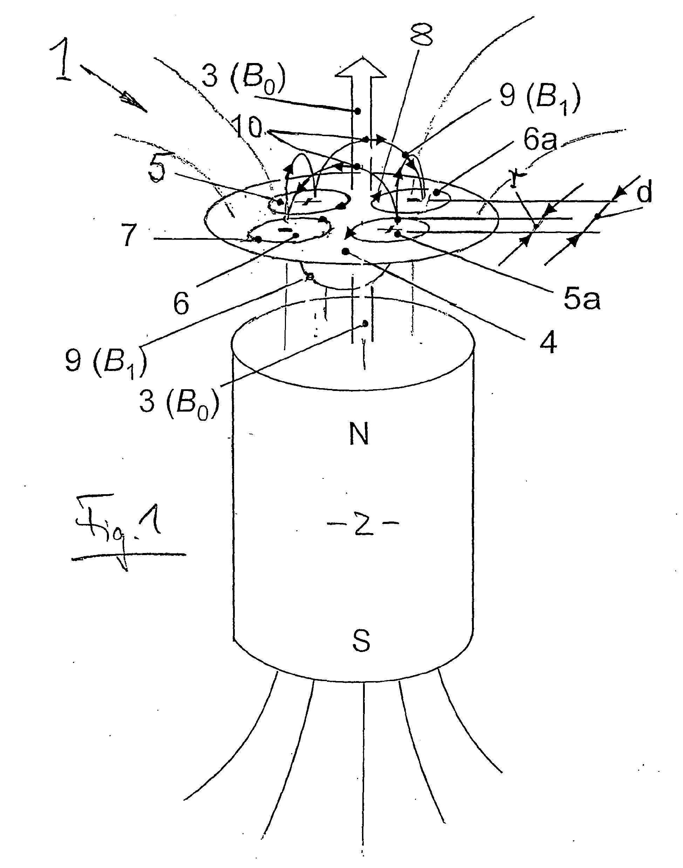

In Figur 1 wird die Erfindung anhand eines prinzipiellen Ausführungsbeispiels näher erläutert. In einer NMR-Sonde 1, beispielsweise vom Typ NMR-MOUSE, sind in einem statischen Polarisationsfeld *B₀,* das von einem Permanentmagneten 2 mit magnetischem Nord(N)- und Süd(S)-Pol erzeugt wird und dessen Magnetfeldlinien 3 in Figur 1 schematisch dargestellt sind, in einer senkrecht zum Polarisationsfeld *B₀* verlaufenden Ebene 4 mehrere Hochfrequenzspulen (HF-Spulen) 5, 5a, 6, 6a angeordnet. Beim Einsatz der NMR-Sonde zur Materialanalyse dienen das Polarisationsfeld *B₀* zur Polarisation der Kernspins im Material, das untersucht werden soll, die HF-Spulen zur Erzeugung gepulster magnetischer Anregungsfelder *B₁,* die dem stark inhomogenen zeitkonstanten permanentmagnetischen Polarisationsfeld *B₀* zur Anregung von Kernspinechos (S) überlagert werden. Die erhaltenen Kernspinechos sind die als Meßsignale zu analysierenden charakteristischen Größen für das mit der NMR-Sonde zu untersuchende Material.

Wegen der Inhomogenität des permanentmagnetischen Polarisationsfeldes *B₀* erfüllen die bekannten NMR-Sonden mit den allein von einer einfachen HF-Spule erzeugten hochfrequenten magnetischen Anregungsfeldern *B₁* nur in wenigen Volumenbereichen des zu untersuchenden Materials die für ein gewünschtes Meßsignal erforderliche Orthogonalitätsbedingung, nämlich daß die Komponenten der beiden zu überlagernden Magnetfelder *B₀* und *B₁* senkrecht aufeinander stehen. In Figur 1 sind der Erfindung gemäß in der Ebene 4 senkrecht zum Polarisationsfeld *B₀* (senkrecht zu den Magnetfeldlinien 3) mehrere flache HF-Spulen 5, 5a, 6, 6a angeordnet, wobei alle HF-Spulen in der Weise eingesetzt sind, daß ihre stromleitenden Leiterschleifen 7 parallel zur Ebene 4 verlaufen und jeweils benachbarte HF-Spulen 5, 6 bzw. 5a, 6a gegenphasig betrieben werden, siehe in Figur 1 die eingezeichneten Stromrichtungspfeile 8 an den Leiterschleifen 7. In Figur 1 ist schematisch pro HF-Spule jeweils nur eine Leiterschleife dargestellt, jede HF-Spule kann selbstverständlich jedoch auch mehrere parallel zur Ebene 4 angeordnete Leiterschleifen, insbesondere spiralförmig verlaufende Spulenwindungen aufweisen. Infolge des gegenphasigen Betriebs von benachbarten HF-Spulen werden zwischen den HF-Spulen jeweils entgegengesetzt gerichtete Magnetfelder ausgebildet. In Figur 1 sind die Richtungen der von den HF-Spulen 5, 5a erzeugten Magnetfelder sinnbildlich mit positivem (+), die von den HF-Spulen 6, 6a erzeugten Magnetfelder mit negativem (-) Vorzeichen angegeben. Zwischen den benachbarten HF-Spulen ergeben sich somit alternierend ausgerichtete Anregungsfelder *B₁* mit Magnetfeldlinien 9 und Querkomponenten 10, die im Magnetfeldraum oberhalb der HF-Spulen senkrecht zum Polarisationsfeld *B₀* verlaufen. Von den Querkomponenten 10 sind in Figur 1 der Übersichtlichkeit halber jeweils nur die Querkomponenten der Anregungsfelder B1 im Scheitel der Magnetfeldlinien 9 dargestellt, die die zur Erzeugung der Meßsignale erforderliche Orthogonalitätsbedingung optimal erfüllen.

Die erzeugten Anregungsfelder *B₁* dringen um so weiter in das zu untersuchende Material ein, je größer die Spulenradien r der Leiterschleifen 7 der HF-Spulen sind. Die Eindringtiefe der Anregungsfelder nimmt mit dem Spulenradius r der jeweils in der Ebene 4 benachbart angeordneten HF-Spulen zu. Mit größer werdenden Spulenradien nimmt zweckmäßiger Weise auch der Abstand d zwischen den HF-Spulen zu, der die Dichte der pro Eindringvolumen erzeugten orthogonalen Querkomponenten bestimmt. Mit zunehmendem Abstand d zwischen den HF-Spulen nimmt die Dichte der pro Eindringvolumen erzeugten orthogonalen magnetischen Querkomponenten ab. Soll mit der NMR-Sonde ein Material bestimmter Dicke untersucht werden, sind Spulenradius r und Abstand d der HF-Spulen derart anzupassen, daß unter Berücksichtigung der Orthogonalitätsbedingungen das Meßvolumen dem zu untersuchenden Materialvolumen bei möglichst hoher Empfindlichkeit entspricht.

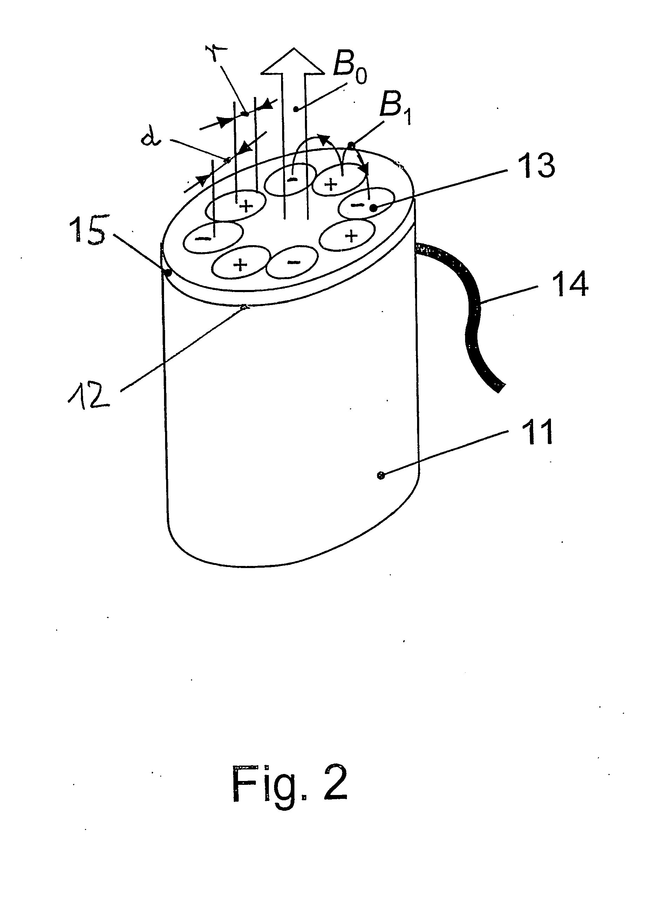

In Figur 2 ist schematisch eine NMR-Sonde wiedergegeben, bei der auf einem stabförmigen Permanentmagneten 11 in einer Ebene senkrecht zum permanentmagnetischen Polarisationsfeld *B₀,* im Ausführungsbeispiel auf einer der Polflächen 12 des Permanentmagneten, acht in der Ebene oktogonal benachbart angeordnete HF-Spulen 13 mit parallel zur Polfläche verlaufenden flachen Leiterschleifen aufgesetzt sind, wobei jeweils benachbarte HF-Spulen gegenphasig betrieben werden und alternierend entgegengesetzt ausgerichtete magnetische Anregungsfelder *B₁* mit zum permanentmagnetischen Polarisationsfeld *B₀* orthogonalen Querkomponenten erzeugen. Die Richtungen der von den HF-Spulen 13 erzeugten Magnetfelder sind sinnbildlich wieder mit positivem (+) und negativem (-) Vorzeichen angegeben. Eindringtiefe und Empfindlichkeit der NMR-Sonde hängen - wie zum Ausführungsbeispiel nach Figur 1 angegeben - vom Spulenradius r der Leiterschleifen und vom Abstand d zwischen benachbarten HF-Spulen 13 ab. Jede der HF-Spulen kann im Ausführungsbeispiel nach Figur 2 jeweils einzeln betrieben werden. Dies hat den Vorteil, daß mit der NMR-Sonde zugleich Mittelwerte der Meßgrößen, die von den einzelnen HF-Spulen (zeitlich versetzt) gemessen werden, aber auch materialspezifische Abweichung der gleichen Meßgrößen an lokal verschiedenen Stellen des Materials, also Varianten der Meßgrößen für örtlich unterschiedliche Materialbereiche ermittelt werden können. Werden die Hf-Spulen nicht jeweils einzeln, sondern - unter Beibehaltung alternierend erzeugter Anregungsfelder - hintereinander geschaltet betrieben, so erhält man bei einer Messung einen Mittelwert der von allen HF-Spulen ermittelten Meßgrößen.

Zur elektrischen Versorgung der HF-Spulen sowie zur Rückübertragung der von den HF-Spulen empfangenen Meßsignale zur Auswertung der Meßergebnisse dient im Ausführungsbeispiel ein mit den HF-Spulen verbundenes HF-Versorgungskabel 14. Im Ausführungsbeispiel sind die HF-Spulen in einem Träger 15 bestehend aus Glas oder Halbleitereinkristallscheiben aufgebracht oder eingebettet, wobei die Oberfläche des Trägers 15 chemisch modifizierbar ist. So läßt sich z.B. zur Verhinderung einer Benetzung der Oberfläche mit Wasser eine hydrophobe Oberfläche schaffen, die - da Wasser Protonen enthält - für ein hintergrundfreies Meßsignal vorteilhaft ist.

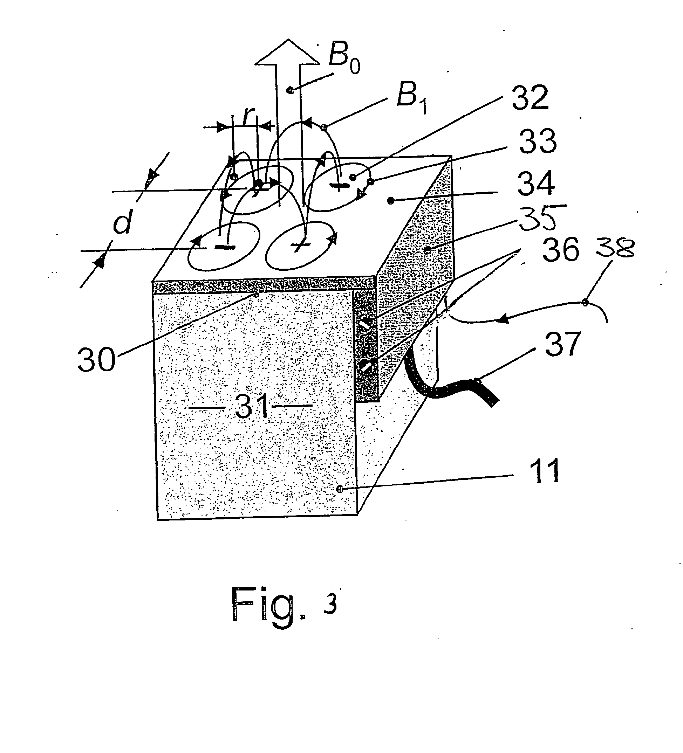

Ein weiteres Ausführungsbeispiel für eine NMR-Sonde ist aus Figur 3 ersichtlich. Bei dieser Sonde sind auf einer der Polflächen 30 eines Vierkant-Stabmagneten 31 vier HF-Spulen 32 (in sogenannter "Kleeblatt-Form" oder in Form einer doppelten "8") angeordnet, von denen schematisch jeweils nur eine Leiterschleife dargestellt ist. Jede HF-Spule kann selbstverständlich auch mehrere parallel zur Polfläche 30 verlaufende Leiterschleifen, insbesondere spiralförmig verlaufende Spulenwindungen aufweisen. Die in den Leiterschleifen gegebenen Stromrichtungen sind in Figur 6 schematisch durch Stromrichtungspfeile 33 angegeben. Die von den Leiterschleifen somit erzeugten alternierend entgegengesetzt gerichteten Magnetfelder sind sinnbildlich wieder mit positivem (+) und negativem (-) Vorzeichen markiert. Zwischen benachbarten Leiterschleifen ergeben sich im Magnetfeldraum oberhalb der HF-Spulen 32 Anregungsfelder *B₁* mit verstärkt orthogonalen Querkomponenten zum Polarisationsfeld *B₀.* Auch bei diesem Ausführungsbeispiel skalieren Eindringtiefe und Empfindlichkeit der NMR-Sonde mit den geometrischen Abmessungen für Spulenradius r der Leiterschleifen und Abstand d zwischen benachbarten HF-Spulen. Je kleinere Spulenradien r die Leiterschleifen aufweisen, um so geringer ist die Eindringtiefe, je dichter sie jedoch auf der Polfläche angeordnet sind, je geringer also ihre Abstände d sind, um so stärker ist die Empfindlichkeit der NMR-Sonde für dünne Materialen.

Die HF-Spulen 32 sind in einem Träger 34 mit einem an einer der Seitenflächen des Stabmagneten 31 zu befestigenden Versorgungsteil 35 eingebettet, der Abstimmungskondensatoren 36 und einen Anschluß für ein HF-Kabel 37 aufweist. Der Träger 34 ist mit einer dünnen Stahlblechunterfläche versehen, die auf einer der Seiten des Stabmagneten 31 haftet. Dies ermöglichst ein bequemes Wechseln von Trägern mit verschiedenen HF-Spulentypen. In den Träger 34 und das Versorgungsteil 35 ist zum Temperieren der HF-Spulen 32 ein Temperatur geregelter Gasstrom 38 einführbar. Die HF-Spulen 32 werden bevorzugt bei Raumtemperatur betrieben.

Für eine Verwendung als Sensor sind unilaterale NMR-Sonden besonders geeignet, da sie oberhalb der HF-Spulen, die das Anregungsfeld erzeugen, mit einer sensorisch reagierenden Schicht bedeckbar sind. Insbesondere NMR-Sonden, bei denen die Stromleiter in Trägern eingebettet sind, siehe Ausführungsbeispiele nach Figuren 2 und 6, lassen sich auf der äußeren Trägeroberfläche mit einer Sensorschicht ausrüsten. Als Sensorschichten bedarf es lediglich geeigneter Folien, da insbesondere NMR-Sonden vom Typ NMR-MOUSE mit durch entsprechende Formgebung der Stromleiter erzeugten alternierenden Anregungsfeldern hohe Empfindlichkeit im oberflächennahen Bereich aufweisen.

### Bezugszeichenliste

Figur 1
   NMR-MOUSE-Sonde 1
   Permanentmagneten 2
   mit magnetischen Nord(N)- und Süd(S)-Pol
   Magnetfeldlinien 3 mit Polarisationsfeld B0
   Ebene 4
   Hochfrequenzspule (HF-Spule) 5, 5a, 6, 6a mit Spulenwindungen mit Spulenradius r und Abstand d zwischen benachbarten HF-Spulen
   Leiterschleife 7
   Stromrichtungspfeil 8
   Magnetfeldlinie 9 des Anregungsfeldes B1
   Querkomponente 10
Figur 2
   Permanentmagnet 11
   Polfläche 12
   HF-Spule 13 mit Spulenradius r und Abstand d zwischen benachbarten HF-Spulen HF-Versorgungskabel 14
   Träger 15
Figur 3
   Polfläche 30
   Stabmagnet 31
   HF-Spule 32 Stromrichtungspfeil 33 Spulenradius r, Abstand d Träger 34
   Versorgungsteil 35 Abstimmungskondensator 36 HF-Kabel 37
   Gasstrom 38

## Patentansprüche

1. NMR-Sonde zur Materialanalyse, mit einem Magneten zur Erzeugung eines konstanten Polarisationsfeldes Bₒ im zu untersuchenden Material und mit an dem Magneten angebrachten flachen Oberflächenspulen zur Erzeugung eines gepulsten hochfrequenten magnetischen im wesentlichen orthogonal zum Polarisationsfeld Bₒ ausgerichteten Anregungsfeldes B1 im Streufeld des Magneten, ausserhalb der sich aus Magnet und Oberflächenspulen zusammensetzenden Sondeneinheit,
**dadurch gekennzeichnet, dass**
es sich bei dem Magneten um einen Stabmagneten (2,11,31) handelt, mit zwei gegenüberliegenden Polflächen (12,30) an den Enden des Magneten und einer diese Enden verbindenden längs des Magneten verlaufenden Seitenfläche, wobei eine der Polflächen eben ist und sich an dieser Polfläche und parallel dazu die Oberflächenspulen befinden, und die Oberflächenspulen zumindest zwei Paare jeweils benachbart angeordneter ringförmiger Leiterschlaufen (7,13,32) enthalten;
und wobei die Sonde derart eingerichtet ist, dass im Betrieb die Schlaufen eines jeden Schlaufenpaares gegenphasig betrieben sind, so dass zwischen ihnen ein Magnetfeld erzeugt wird, das ungefähr senkrecht verläuft zu dem aus der Polfläche austretenden Magnetfeld, und dass das von dem ersten Schlaufenpaar derart erzeugte transversale Magnetfeld entgegengerichtet ist zu dem entsprechenden vom zweiten Schlaufenpaar erzeugten Magnetfeld.

2. NMR-Sonde nach Anspruch 1, **dadurch gekennzeichnet, dass** die benachbart angeordneten Leiterschlaufen zumindest eine in Form der Zahl "8" verlaufende Leiterschleife (32) aufweisen.

3. NMR-Sonde nach Anspruch 1 oder 2, **dadurch gekennzeichnet, dass** zur Ausbildung der beiden Paare benachbart angeordneter Leiterschlaufen eine Leiterschleife (32) in Form eines vierblättrigen Kleeblattes eingesetzt ist.

4. NMR-Sonde nach einem der vorhergehenden Ansprüche 1 bis 3,
**dadurch gekennzeichnet, dass** die Oberflächenspulen (13, 32) in oder auf einem Träger (15, 34) mit hydrophober Oberfläche aufgebracht sind

5. NMR-Sonde nach einem der vorhergehenden Ansprüche 1 bis 4, **dadurch gekennzeichnet, dass** die Oberflächenspulen (13, 32) in oder auf einem Träger (15, 34) aufgebracht sind, der eine magnetisch auf dem Polarisationsmagneten der Sonde haftende Halterung aufweist.

6. NMR-Sonde nach Anspruch 5, **dadurch gekennzeichnet, dass** als Halterung ein am Träger (34) befestigtes Stahlblech dient.

7. NMR-Sonde nach einem der Ansprüche 1 bis 6, **dadurch gekennzeichnet, dass** die Oberflächenspulen auf ihrer dem Poiarisationsmagneten entgegengesetzten freien Oberfläche mit einer Schicht überzogen sind, die auf ihr äußeres Umfeld sensorisch derart reagiert, dass sich die von den Anregungsfeldem erzeugten Echosignale S ändern.

8. NMR-Sonde nach Anspruch 7, **dadurch gekennzeichnet, dass** die Oberflächenspulen von einer sensorisch reagierenden Folie bedeckt sind.

9. NMR-Sonde nach Anspruch 7 oder 8, **dadurch gekennzeichnet, dass** die Oberflächenspulen eine Beschichtung aufweisen, die chemisch funktionalisierte Moleküle enthält.

## Claims

1. An NMR probe for material analysis with a magnet for generating a constant polarization field B₀ in the material to be analysed and with flat surface coils attached to the magnet for generating a pulsed highfrequency magnetic excitation field B₁ substantially oriented orthogonally to the polarization field B₀ in the stray field of the magnet, outside the probe unit consisting of magnet and surface coils, **characterized in that** the magnet is a bar magnet (2,11,31) with two opposing pole surfaces (12,30) at the ends of the magnet and a lateral surface joining these ends running alongside the magnet, wherein one of the pole surfaces is flat and the surface coils are located on this pole surface and parallel to this pole surface, and the surface coils contain at least two pairs of annular conductor loops (7,13,32) each arranged adjacently; and
wherein the probe is equipped in such a manner that in operation the loops of each of the loop pairs are operated in phase opposition so that between them a magnetic field is generated which approximately runs vertically to the magnetic field emanating from the pole surface and that the transversal magnetic field generated in such a manner from the first loop pair is directed opposite to the corresponding magnetic field generated by the second loop pair.

2. The NMR probe according to Claim 1, **characterized in that** the conductor loops arranged adjacently at least have one conductor loop (32) which runs in form of the Figure "8".

3. The NMR probe according to Claim 1 or 2, **characterized in that** for forming the conductor loops arranged adjacent to the two pairs a conductor loop (32) in form of a four-leafed clover is employed.

4. The NMR probe according to any one of the preceding Claims 1 to 3, **characterized in that** the surface coils (13,32) are mounted in or on a carrier (15,34) with hydrophobic surface.

5. The NMR probe according to any one of the preceding Claims 1 to 4, **characterized in that** the surface coils (13,32) are mounted in or on a carrier (15,34) which comprises a holder that magnetically adheres to the polarization magnet of the probe.

6. The NMR probe according to Claim 5, **characterized in that** a steel plate attached to the carrier (34) serves as holder.

7. The NMR probe according to any one of the Claims 1 to 6, **characterized in that** the surface coils on their free surface opposite to the polarization magnet are coated with a layer which reacts in a sensory manner to its external surroundings in such a manner that the echo signals S generated by the excitation fields change.

8. The NMR probe according to Claim 7, **characterized in that** the surface coils are covered by a foil which reacts in a sensory manner.

9. The NMR probe according to Claim 7 or 8, **characterized in that** the surface coils have a coating which contains chemically functionalized molecules.

## Revendications

1. Sonde RMN pour l'analyse de matières, avec un aimant pour la création d'un champ de polarisation constant *B₀* dans la matière à examiner et avec des bobines superficielles plate montées sur l'aimant, pour la création d'un champ d'excitation magnétique haute fréquence pulsé *B₁,* sensiblement orthogonal au champ de polarisation *B₀,* dans le champ de dispersion de l'aimant, à l'extérieur de l'unité de sonde composée de l'aimant et des bobines superficielles, **caractérisée en ce que**
en ce qui concerne l'aimant, il s'agit d'un barreau aimanté (2, 11, 31), avec deux faces polaires (12, 30) opposées sur les extrémités de l'aimant et avec une surface latérale reliant lesdites extrémités, s'étendant le long de l'aimant, l'une des faces polaires étant plane et les bobines superficielles se trouvant sur ladite face polaire, à la parallèle de celle-ci et les bobines superficielles comprenant au moins deux paires de boucles de conducteurs annulaires (7, 13, 32), respectivement disposées en contigu ; et la sonde étant installée de sorte que soit créé entre elles un champ magnétique qui s'étend environ à la perpendiculaire du champ magnétique sortant de la face polaire, et **en ce que** le champ magnétique transversal créé, de la sorte par la première paire de boucles est opposé au champ magnétique correspondant, créé par la deuxième paire de boucles,

2. Sonde RMN selon la revendication 1, **caractérisée en ce que** les boucles de conducteurs disposées en contigu comportent au moins une boucle conductrice (32) s'étendant sous la forme du chiffre "8".

3. Sonde RMN selon la revendication 1 ou 2, **caractérisée en ce que**, pour la réalisation des deux paires de boucles de conducteurs disposées en contigu, on utilise une boucle conductrice (32) de la forme d'un trèfle à quatre feuillés.

4. Sonde RMN selon l'une quelconque des revendications précédentes 1 à 3, **caractérisée en ce que** les bobines superficielles (13, 32) sont montées dans ou sur un support (15, 34) à surface hydrophobe.

5. Sonde RMN selon l'une quelconque des revendications 1 à 4, **caractérisée en ce que** les bobines superficielles (13, 32) sont montées dans ou sur un support (15, 34), comportant une embase adhérant de façon magnétique sur l'aimant de polarisation de la sonde.

6. Sonde RMN selon la revendication 5, **caractérisée en ce qu'**une tôle d'acier fixée sur le support (34) sert d'embase.

7. Sonde RMN selon l'une quelconque des revendications 1 à 6, **caractérisée en ce que**, sur leur surface libre opposée à l'aimant de polarisation, les bobines superficielles sont revêtues d'une couche, qui sur son champ périphérique extérieur fait preuve d'une réaction sensorielle, de sorte que les signaux de l'écho S créés par les champs d'excitation se modifient.

8. Sonde RMN selon la revendication 7, **caractérisée en ce que** les bobines superficielles sont recouvertes d'un film à réaction sensorielle.

9. Sonde RMN selon la revendication 7 7 ou 8, **caractérisée en ce que** les bobines superficielles comportent un revêtement, qui contient des molécules chimiquement fonctionnalisées.
